# EUROPEAN PATENT APPLICATION

(11) **EP 2 955 244 A1**
(43) Date of publication of application: **16.12.2015**
(21) Application number: 14748572.6
(22) Date of filing: 09.01.2014
(51) Int. Cl.: C23C 14/02

(54) **ION BOMBARDMENT DEVICE AND SUBSTRATE SURFACE CLEANING METHOD USING SAME**

(30) Priority: 07.02.2013 JP 2013022264
(71) Applicant: Kabushiki Kaisha Kobe Seiko Sho (Kobe Steel, Ltd.), Kobe-shi, Hyogo 651-8585 (JP)
(72) Inventor: HIROTA, Satoshi, Takasago-shi Hyogo 676-8670 (JP); NOMURA, Homare, Takasago-shi Hyogo 676-8670 (JP)
(74) Representative: TBK
(86) International application number: PCT/JP2014/000047
(87) International publication number: WO 2014/122876

(57) **Abstract**

Provided is an ion bombardment device (1) for stabilizing and cleaning the surface of a substrate. The device is provided with the following: a vacuum chamber (2); at least one electrode (3) that is disposed on the inner wall face of the vacuum chamber (2) and emits electrons; a plurality of anodes (4) that receive the electrons from the electrode (3) and that are arranged so as to face the electrode with the substrate sandwiched therebetween; and a plurality of discharge power sources (5) corresponding to the anodes (4) respectively. Each of the discharge power sources (5) is insulated from the vacuum chamber (2) and provides to the anode (4) corresponding to the relevant discharge power source (5) currents and voltages that can be set independently of one another, thereby generating a glow discharge between such anode (4) and the electrode (3).

## Description

### TECHNICAL FIELD

The present invention relates to an ion bombardment device for cleaning a substrate surface as a pretreatment prior to deposition and a method for using the device to clean a substrate surface.

### BACKGROUND ART

Generally, a hard coating is deposited onto a surface of a substrate (substrate to be deposited) by a PVD process or a CVD process to improve the wear resistance of cutting tools or to increase slidability of a sliding surface of mechanical components. Example of devices for use in such deposition of a hard coating include physical vapor deposition apparatuses such as arc ion plating apparatuses and sputtering apparatuses and chemical vapor deposition apparatuses such as plasma CVD apparatuses.

It is known to clean a substrate surface prior to deposition treatment to achieve deposition of a highly-adherent hard coating using a physical vapor deposition apparatus or a chemical vapor deposition apparatus. Cleaning by electron bombardment heating and ion bombardment treatment are known for cleaning a substrate surface. In the ion bombardment treatment, heavy inert gas ions such as argon ions are generated by plasma discharge, and irradiation of a substrate with these ions heats the substrate surface. Then the heating cleans the target surface.

Patent Document 1 discloses a technique for cleaning a substrate surface in a cylindrical vacuum chamber that has a vertical center axis. In the technique, a plurality of substrates are disposed around the center axis of the vacuum chamber. On the inner circumferential side or the outer circumferential side of the substrates, an arc discharge, which is a plasma source, is formed in a region at a level that is the same as or higher than a level where the substrates are to be treated. Then, the substrates that have negative bias voltage applied thereto are collided with argon ions generated by the arc discharge, thereby cleaning the surface of the substrates.

When the device described in Patent Document 1 is used to clean a substrate surface, there is a concern that the substrates cannot be effectively cleaned, depending on the size or the location of the substrates placed in the vacuum chamber. In particular, in the vacuum chamber under an inert gas, a potential difference is applied between a cathode (negative electrode) that emits electrons and an anode (positive electrode) that receives the electrons to cause a discharge, which transfers the electrons emitted from the cathode toward the anode. If a substrate placed in the vacuum chamber has a large size, or if a plurality of substrates are densely disposed, the transfer of the electrons between the cathode and the anode may be inhibited. Thus, many of the emitted electrons can move disproportionately toward smaller substrates, or toward a region where substrates are sparsely placed or where no substrates are placed.

This means that when differences in the size or the location of substrates disposed in the vacuum chamber result in a region where there are many electrons and a region where there are fewer electrons, high-density plasmas can be generated in the region where there are many electrons, while low-density plasmas can be generated in the region where there are fewer electrons. Cleaning of substrates in the vacuum chamber that has such a non-uniform plasma density causes variations in the degree of cleaning of the substrate surfaces, that is, the amount of material removed from the substrate surfaces by ion impact (etch amount). In particular, if substrate surfaces are etched in the region of high plasma density, too much material may be removed from the substrate surfaces. In contrast, if substrates are etched in the region of low plasma density, the etch amount of the substrate surfaces may be less than desirable.

Such variations in the etch amount of the substrates may prevent uniform deposition of a hard coating onto the substrate surfaces and may prevent improvement in, for example, the wear resistance of the substrates.

### CITATION LIST

### PATENT DOCUMENT

Patent Document 1: JP 4208258 B

### SUMMARY OF THE INVENTION

It is an object of the present invention to provide an ion bombardment device for cleaning a substrate surface, the device being capable of stably cleaning the substrate surface regardless of variations in the size and the location of the substrate, and a method for using the device to clean a substrate surface.

The present invention provides an ion bombardment device for cleaning a substrate surface, the device including a vacuum chamber that has an inner wall enclosing a space for containing the substrate, at least one electrode that is disposed on a face of the inner wall of the vacuum chamber and that emits electrons, a plurality of anodes that receive the electrons from the electrode and that are arranged so as to face the electrode across the substrate, and a plurality of discharge power sources that correspond to the respective anodes. Each of the discharge power sources is insulated from the vacuum chamber and provides an independently settable current or voltage to the anode that corresponds to the discharge power source to generate a glow discharge between the anode and the electrode.

A method for cleaning a substrate surface according to the present invention is a method for using the ion bombardment device as described above to clean the surface of a substrate prior to deposition, the substrate having a longitudinal direction, and the method includes placing the substrate in a space in the vacuum chamber so that the substrate is located between the at least one electrode and the anodes of the ion bombardment device, generating a glow discharge between the anodes and the electrode with the substrate placed to generate plasmas, and controlling at least one of a discharge current and a discharge voltage provided by the discharge power sources to achieve uniform density of the generated plasmas in the longitudinal direction of the substrate.

### BRIEF DESCRIPTION OF DRAWINGS

[Fig. 1] Fig. 1 is a front cross-sectional view of an ion bombardment device according to a first embodiment of the present invention.
[Fig. 2] Fig. 2 is a plan cross-sectional view of the ion bombardment device according to the first embodiment.
[Fig. 3] Fig. 3 is a graph illustrating the operating range of a discharge power source in the ion bombardment device.
[Fig. 4A] Fig. 4A illustrates a first placement of a substrate and an exemplary setting of the discharge-currents in the ion bombardment device.
[Fig. 4B] Fig. 4B illustrates a second placement of substrates and an exemplary setting of the discharge-currents in the ion bombardment device.
[Fig. 5] Fig. 5 is a graph illustrating the distribution of the etch amount of a substrate with and without control of the discharge currents.
[Fig. 6] Fig. 6 is a front cross-sectional view of an ion bombardment device according to a second embodiment of the present invention.
[Fig.7] Fig. 7 is a plan cross-sectional view of an ion bombardment device according to a third embodiment of the present invention.
[Fig.8] Fig. 8 is a plan cross-sectional view of an ion bombardment device according to a fourth embodiment of the present invention.

### DESCRIPTION OF EMBODIMENTS

Hereinafter, embodiments of the present invention will be described with reference to the drawings.

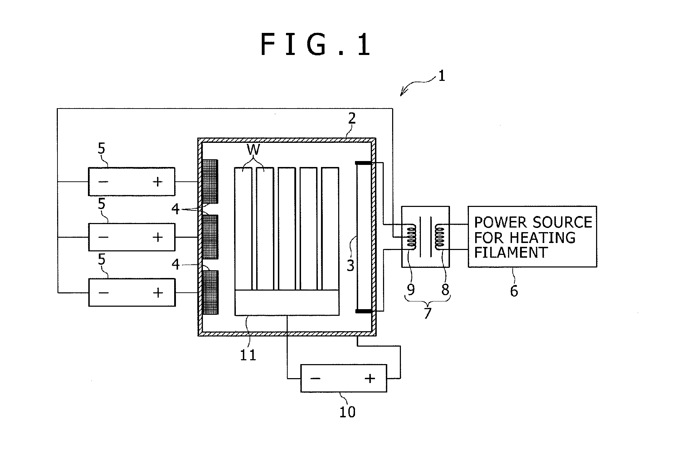

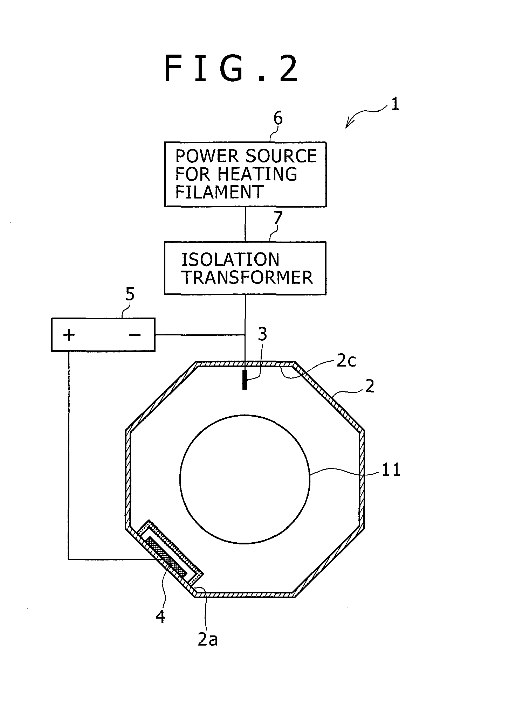

Fig. 1 and Fig. 2 illustrate an ion bombardment device 1 according to a first embodiment of the present invention. The ion bombardment device 1 is a device for cleaning a surface of a substrate W prior to deposition of a coating by physical vapor deposition (PVD) or chemical vapor deposition (CVD). The ion bombardment device 1 includes a vacuum chamber 2 for containing the substrate W, and functions to clean the substrate W by irradiating the substrate W placed in the vacuum chamber 2 with gas ions generated in the vacuum chamber 2.

Examples of the substrate W to be cleaned by the ion bombardment device 1 may include various articles such as, for example, cutting tools and press-molds. In a cutting or pressing operation, a heavy load is applied to such cutting tools or molds, which thus require high wear resistance and high slidability. To provide such properties, PVD or CVD is used to deposit a hard coating (such as TiN and TiAlN coatings) onto the surface of the substrate W. Such deposition of a highly-adherent hard coating by physical vapor deposition or chemical vapor deposition requires cleaning of the surface of the substrate W prior to the deposition treatment. In the ion bombardment device 1, heavy inert gas ions such as argon ions are generated by plasma discharge, and the substrate W is collided with the ions to heat the surface of the substrate W. This heating cleans the surface of the substrate W.

Hereinafter, the ion bombardment device 1 according to the first embodiment will be described in detail. In the following description, "vertical direction" refers to the vertical direction in Fig. 1, and "lateral direction" refers to the lateral direction in Fig. 1.

As illustrated in Fig. 1 and Fig. 2, the ion bombardment device 1 according to the first embodiment includes an electrode 3, which is a cathode that emits electrons, a plurality of anodes 4 that receive the electrons from the electrode 3, and a rotatable work table 11. The work table 11 corresponds to a substrate holder on which a plurality of substrates W to be cleaned can be placed.

The ion bombardment device 1 further includes discharge power sources 5, a heating power source 6, and a bias power source 10. The discharge power sources 5 apply a potential difference between the electrode 3 and the anodes 4 to generate a plasma discharge. The heating power source 6 is a power source for heating the electrode 3. The bias power source 10 is connected to the work table 11 and applies a negative voltage to substrates W placed on the work table 11.

As illustrated in Fig. 2, the vacuum chamber 2 according to the embodiment is a hollow housing having an octagonal plan view shape and has a plurality of faces of an inner wall enclosing a space for containing the plurality of substrates W. The pressure within the vacuum chamber 2 can be reduced to vacuum conditions, and the vacuum chamber 2 is configured to be sealed in a gas-tight manner to maintain the vacuum within the chamber. Although not shown, the vacuum chamber 2 includes a gas inlet for introducing an inert gas such as argon into the vacuum chamber 2 and a gas outlet for removing the inert gas from the vacuum chamber 2.

The work table 11 is a stage plate having a circular plan view shape. The work table 11 is disposed on the bottom of the vacuum chamber 2 so that the work table 11 can be rotated around a vertical axis located at approximately the center of the bottom of the vacuum chamber 2. The plurality of substrates W is placed upright on the work table 11. In particular, each of the substrates W has a longitudinal direction, that is, is elongated in a certain direction. Each of the substrates W is placed on the work table 11 so that its longitudinal direction is oriented in the vertical direction. The electrode 3 and the anodes 4 are opposed to the respective lateral sides of the work table 11.

The electrode 3 (cathode or negative electrode) emits electrons and is disposed on one face of the inner wall of the vacuum chamber 2. In particular, the electrode 3 is disposed so as to face the anodes 4 across the substrates W. The electrode 3 is elongated in a certain direction and is disposed so that its longitudinal direction is oriented in the longitudinal direction of the substrates W, that is, in the vertical direction.

The electrode 3 according to the first embodiment includes an elongated filament, in particular, a threadlike structure formed from a metal such as tungsten (W). In the ion bombardment device 1 according to the first embodiment, the substrates W are placed upright on the work table 11, and the electrode 3 that includes the elongated filament as described above is connected to one face of the inner wall of the vacuum chamber 2 via an insulator so that the longitudinal direction of the electrode is oriented in the vertical direction. The electrode 3 has a length that is the same as or slightly longer than the total height of the substrates W placed on the work table 11, that is, the height of the substrates W to be treated.

As illustrated in Fig. 1, the electrode 3 is aligned with the substrates W, as viewed from the side. In particular, the top end of the electrode 3 extends higher than the top end of the substrates W, and the bottom end of the electrode 3 extends lower than the bottom end of the substrates W. The electrode 3 has a uniform thickness and a uniform composition across the vertical direction.

As illustrated in Fig. 2, the electrode 3 is disposed on one face of the inner wall of the vacuum chamber 2 having an octagonal plan view shape, the face corresponding to one side of the octagon and to the upper side or a face 2c in Fig. 2. Although not shown, an auxiliary electrode may be disposed in the vacuum chamber 2 for when the electrode 3 is consumed and spent due to repeated cleanings of substrates W.

The heating power source 6 is connected to both ends of the electrode 3. The heating power source 6 provides a current to the electrode 3 to heat the electrode 3, which is thus caused to emit electrons. The substrates W are approximately uniformly irradiated, across the treating-height direction, with the electrons emitted from the electrode 3. The quantity of electrons emitted toward the substrates W can be controlled by the potential of the electrode 3 at the respective locations. The emitted electrons impact argon gas introduced into the vacuum chamber 2 to generate argon ions.

The configuration of the electrode according to the present invention is not limited to a filament electrode like the electrode 3. For example, the electrode may be a rectangular or needle electrode. Unlike the filament electrode 3, such electrode is not elongated. Thus, the electrons are widely distributed, and the plasmas generated also widely diffuse. The electrode according to the present invention may also be an electron source such as an electron-emitting plasma source. Such electron source is smaller than the filament electrode 3 and can uniformly distribute the plasmas.

To each of the anodes 4 (positive electrodes), a positive potential (a potential relatively higher than that of the electrode 3) is applied. Each of the anodes 4 is disposed on another face (face 2a) of the inner wall of the vacuum chamber 2, the face facing the electrode 3 across the work table 11. The anodes 4 are arranged in the longitudinal direction of the substrates W, that is, the vertical direction. In the ion bombardment device 1 according to the first embodiment, the substrates W are placed on the work table 11 so that their longitudinal direction is oriented in the vertical direction. And the anodes 4 are mutually spaced at a plurality of locations (three locations in Fig. 1) in the vertical direction.

The area in which the plurality of anodes 4 are disposed extends in the vertical direction slightly higher and slightly lower than the area of the substrates W placed on the work table 11, the area corresponding to the total length (cleaning length) of the substrates W, as viewed from the side. In particular, the top end of one of the plurality of anodes 4 that is disposed in an upper portion of an inner wall face of the vacuum chamber 2 extends slightly higher than the top end of the substrates W, and the bottom end of the anode 4 that is disposed in a lower portion of the inner wall face of the vacuum chamber 2 extends slightly lower than the bottom end of the substrates W. The anode 4 that is disposed in the middle of the inner wall face of the vacuum chamber 2 is disposed between the anode 4 that is disposed in an upper portion of the inner wall face of the vacuum chamber 2 and the anode 4 that is disposed in a lower portion of the inner wall face of the vacuum chamber 2. And the middle anode 4 is spaced equally (on the same pitch) along the longitudinal direction of the substrates W from the upper anode 4 and the lower anode 4.

Then, the discharge power sources 5 that are individually connected to each of the plurality of anodes 4 arranged in the longitudinal direction of the substrates W (in the vertical direction in the embodiment) provide a current to the respective anodes 4. And individual adjustment of at least one of the current and the voltage provided to each of the anodes 4 to control electrons that flow into each of the anodes 4 allows the plasmas to be approximately uniformly distributed in the vertical direction. In some cases, it is preferred to intentionally increase or decrease the cleaning amount (amount of material removed from the surface of the substrates W by plasma, that is, etch amount), depending on the size and the shape of the substrates W to be treated. In such case, the discharge power sources 5 may be controlled so that the plasmas are non-uniformly distributed.

In some cases, a PVD apparatus is used as the ion bombardment device 1, or ion bombardment is performed in a PVD apparatus prior to PVD (a PVD apparatus serves an additional function as the ion bombardment device 1). In such case, a cathode of the PVD apparatus, that is, an evaporation source used in depositing a coating, serves an additional function as an anode 4 of the ion bombardment device 1.

Such additional use eliminates the need to provide an additional anode 4 in the vacuum chamber 2, and thus has the advantage that the operation is achieved only by providing a simple circuit switch, while reducing production costs. In this case, the anode 4 is heated to a very high temperature by electrons that flow into the anode 4, and thus the evaporation source of the PVD apparatus includes a cooling mechanism to reduce temperature rise in the generation of plasmas. The ion bombardment device 1 can also effectively use the cooling mechanism, and thus the need for an additional cooling mechanism can be eliminated.

If the evaporation source of the PVD apparatus includes a magnetic field generator for generating a magnetic field to control discharge, the magnetic field generator can be used to control electrons emitted from the electrode 3 in the ion bombardment. In particular, the magnetic field generated by the magnetic field generator efficiently traps electrons that flow into the anode 4, thereby stabilizing a discharge between the electrode 3 and the anode 4. If the anode 4 has a large area, plasmas can also be generated uniformly in the chamber.

The heating power source 6 is an AC power source for providing a current to the electrode 3 to heat the electrode 3, which allows irradiation of the substrates W with electrons. The heating power source 6 is not directly connected to the electrode 3, and is connected via an isolation transformer 7 in an electrically isolated condition. The isolation transformer 7 has a primary coil 8 on the input (the side opposed to the heating power source 6) and a secondary coil 9 on the output (the side opposed to the electrode 3), and the ratio of turns of the coils 8 and 9 is 1:1.

Such configuration causes an alternating current from the heating power source 6 to flow via the isolation transformer 7 to the electrode 3. Then, the electrode 3 is heated, and electrons are emitted from the electrode 3. The isolation transformer 7 includes, on the side having the primary coil 8, an element such as a power regulator (not shown) for controlling the phase of the alternating current from the heating power source 6.

As illustrated in Fig. 1, the discharge power sources 5 are a DC power source that applies a potential difference between the respective anode 4 corresponding to the respective discharge power source 5 and the electrode 3 to generate a discharge. The positive pole of the discharge power sources 5 is connected to the respective anode 4, and the negative pole of the discharge power sources 5 is connected via the isolation transformer 7 to the electrode 3. In particular, the negative pole of the discharge power sources 5 is connected to a center tap disposed in the middle of the turns of the secondary coil 9 and is connected via the secondary coil 9 to the electrode 3.

Each of the discharge power sources 5 can individually control a discharge current between the electrode 3 and the respective anode 4 or a discharge voltage between the electrode 3 and the respective anode 4. The discharge current or the discharge voltage between the electrode 3 and each of the anodes 4 can be individually adjusted depending on the substrates W and their locations to adjust the density of the plasmas generated between each of the anodes 4 and the electrode 3 so that the density is approximately uniform in the longitudinal direction of the substrates W. This allows effective cleaning of the substrates W.

Each of the discharge power sources 5 may be able to control at least one of the discharge current and the discharge voltage. Preferably, the discharge power sources 5 may be an "automatic-switching DC-stabilized power source" that can have various combinations of voltage and current settings within a range of the rated output power. Use of discharge power sources 5 that have such a wide range (a variation range that is 2-10 times wider than that of usual power sources) eliminates the need to provide a plurality of power sources for various discharge states. Even if the number and the location of the substrates W are changed, and then the glow discharge state between the electrode 3 and the anodes 4 is changed, it can be insured that the changes are accommodated.

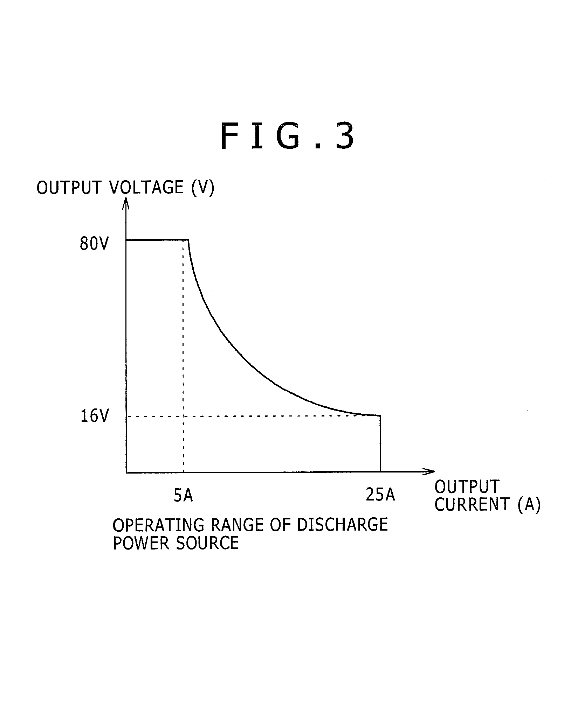

Fig. 3 illustrates the operating range of the automatic-switching DC-stabilized power source as described above. As illustrated in Fig. 3, if, for example, the output current is controlled to be within 5 A, the output voltage is controlled to be a constant value of 80 V. If the output current is controlled to be above 5 A, the output voltage is controlled to be less than 80 V. For example, when the output current is 25 A, the output voltage is controlled to be 16 V. Such control of the discharge current can cause a large change in the discharge voltage. This allows a change in the glow discharge between the electrode 3 and the anodes 4 to be accommodated.

The bias power source 10 is a DC power source that applies, to the substrates W, a negative charge relative to the vacuum chamber 2. The positive pole of the bias power source 10 is connected to the vacuum chamber 2, and the negative pole is connected via the work table 11 to the substrates W. The bias power source 10 is configured to apply a negative voltage of 10-1000 V to the substrates W.

Hereinafter, a method for using the ion bombardment device 1 according to the first embodiment to clean the surface of the substrates W will be described with reference to the drawings.

As illustrated in Fig. 1 and Fig. 2, first, a plurality of the substrates W to be cleaned are placed on the rotatable work table 11 (having, for example, a diameter of 130 mm and a height of 600 mm) disposed in the vacuum chamber 2, and then the inside of the chamber 2 is evacuated to form a near vacuum. Then, an inert gas such as argon gas is introduced into the vacuum chamber 2. The introduction rate is, for example, about 360 ml/min. Then, a heater (not shown) disposed in the vacuum chamber 2 is activated to heat the surface of the substrates W to a temperature suitable for the cleaning. The argon gas may be introduced simultaneously with the evacuation of the vacuum chamber 2.

Next, in the vacuum chamber 2 filled with the introduced argon gas, each of the discharge power sources 5 provides a controlled current to the respective anode 4. Then, with a potential difference applied between the electrode 3 and each of the anodes 4, the heating power source 6 provides an alternating current via the isolation transformer 7 to the electrode 3. The provision of the alternating current causes the electrode 3 to emit electrons. The emitted electrons flow toward each of the anodes 4 at a relatively positive potential to generate a glow discharge between the electrode 3 and each of the anodes 4. This causes the argon gas adjacent to the substrates W to be ionized to form plasmas, thereby generating positively-charged argon ions adjacent to the substrates W.

In the generation of the glow discharge, the heating-current provided to the electrode 3 is increased. This increases the pressure of the argon gas in the vacuum chamber 2. The increased pressure facilitates the generation of the glow discharge between the electrode 3 and each of the anodes 4. When the glow discharge is begun, the gas pressure in the vacuum chamber 2 is reduced to a set value at which the glow discharge can be maintained, and the current for heating the filament that constitutes the electrode 3 is adjusted so that the discharge voltage is appropriate.

The bias power source 10 connected via the work table 11 to the vacuum chamber 2 is turned on during the generation of the plasmas to apply, to each of the substrates W placed on the work table 11, a negative bias voltage relative to the vacuum chamber 2. After the negative bias voltage is applied to each of the substrates W, the surface of each of the substrates W is collided with the argon ions to clean the surface of the substrates W. When the cleaning proceeds, and then the surface of the substrates W is determined to have been etched as desired, each of the power sources of the ion bombardment device 1 is turned off to complete the cleaning of the surface of the substrates W.

The process described above is conducted by a program in a controller (not shown) disposed in the ion bombardment device 1. The controller controls each of the power sources and the pressure of the argon gas in accordance with a pre-programmed program.

As described above, use of the ion bombardment device 1 according to the first embodiment allows the substrates W to be irradiated with electrons uniformly along the height, thereby uniformly cleaning the substrates W.

Now, a method for using the ion bombardment device 1 according to the first embodiment to clean the surface of the substrates W will be specifically described.

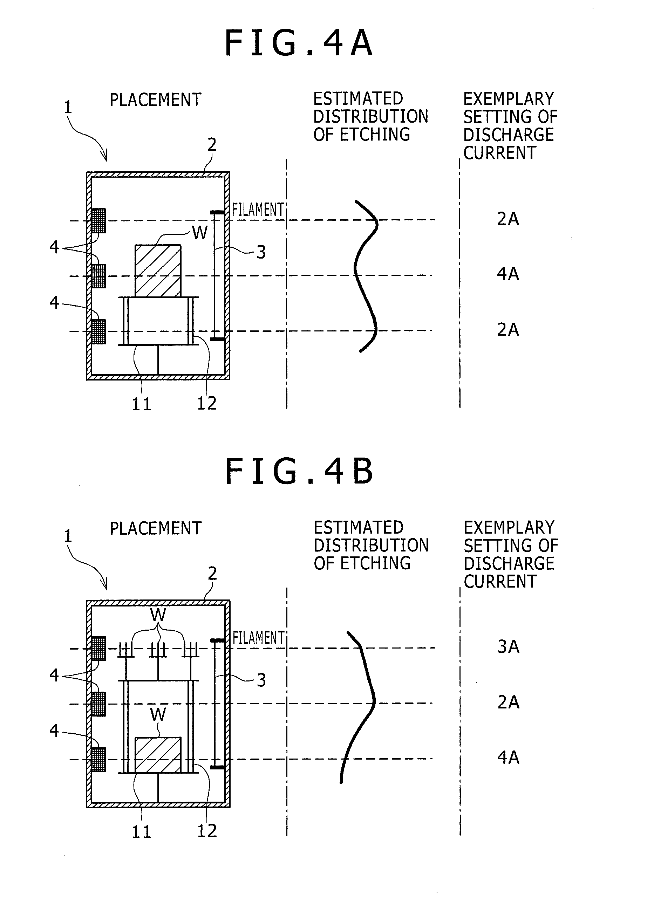

Fig. 4A and Fig. 4B illustrate an example of control of the discharge power sources 5 to approximately uniformly etch the substrates W in the ion bombardment device 1 according to the first embodiment.

In the example illustrated in Fig. 4A, a stand 12 that has a plurality of elongated legs is disposed on the work table 11 disposed in the vacuum chamber 2, and a substrate W to be cleaned is placed on the stand 12. The placement of the substrate W on the stand 12 that has long legs allows the substrate W to be approximately centered vertically in the vacuum chamber 2.

Thus, when the substrate W is placed in the vacuum chamber 2 as illustrated in Fig. 4A, the material amount and the placement of the substrate W vary with the vertical areas. In the lower area of the vacuum chamber 2, the area including the work table 11, only legs of the stand 12 are disposed, and no other features are disposed. In the vertical central area of the vacuum chamber 2, the substrate W is placed on the stand 12, and the substrate W is opposed to one of the plurality of anodes 4 that is centered vertically in an inner wall face of the vacuum chamber 2. In the area above the substrate W, that is, the upper area of the vacuum chamber 2, no features including the substrate W are disposed. This means that the upper area includes no substrate W.

In the above condition of placement of the substrate W, control of each of the discharge power sources 5 of the ion bombardment device according to the present invention when cleaning the substrate W allows the surface of the substrate W to be approximately uniformly etched. For example, it is preferred to respectively control the discharge current from the discharge power source 5 in the upper area, the discharge current from the discharge power source 5 in the central area, and the discharge current from the discharge power source 5 in the lower area to be 2 A, 4 A, and 2 A. In other words, it is preferred to control the current for the area that includes an object (substrate W) to be higher and to control the current for the area that includes no object to be lower.

Such control of the discharge current from the discharge power sources 5 depending on the condition of placement of the substrate W allows the plasma density in the vacuum chamber 2 to be approximately uniform, thereby approximately uniformly irradiating the surface of the substrate W with the ion gas. The lateral central portion of Fig. 4A shows a curve schematically illustrating the distribution of the etch amount of the surface of the substrate W. The fact that the curve is similar to the vertical line can confirm that the etch amount of the surface of the substrate W is approximately uniform in the vertical direction.

In the example illustrated in Fig. 4B, a stand 12 that has a plurality of elongated legs is disposed on the work table 11 disposed in the vacuum chamber 2. The stand 12 has longer legs compared with the stand 12 illustrated in Fig. 4A. Thus, even when a small substrate W such as, for example, a cutting tool is placed on the stand 12, the substrate can be disposed in the upper area of the vacuum chamber 2. On the work table 11 under the stand 12, a large substrate W such as, for example, a mold is placed. The large substrate W is placed between the legs of the stand 12 on the work table 11.

When the substrates W are placed in the vacuum chamber 2 as illustrated in Fig. 4B, the material amount and the placement of the substrates W vary with the vertical areas. In the lower area of the vacuum chamber 2, the area including the work table 11, the large substrate W is placed, and the area has the substrate W densely. In the vertical central area of the vacuum chamber 2, only legs of the stand 12 are disposed, and no substrates W are placed. In the upper area of the vacuum chamber 2, small substrates W are spaced on the stand 12.

When cleaning the surface of the substrates W that are placed as described above, control of the discharge power sources 5 of the ion bombardment device according to the present invention allows the surface of the substrates W to be approximately uniformly etched. For example, it is preferred to respectively control the discharge current from the discharge power source 5 in the upper area, the discharge current from the discharge power source 5 in the central area, and the discharge current from the discharge power source 5 in the lower area to be 3 A, 2 A, and 4 A. In other words, it is preferred to control the current for the areas that include an object (substrate W) to be higher and to control the current for the area that includes no object to be lower. For the area in which the objects are spaced, it is preferred to control the current to be moderate. Such control of the discharge current of the discharge power sources 5 depending on the placement of the substrates W allows the plasmas to be approximately uniformly distributed in the areas of the vacuum chamber 2, the areas including a substrate W (an object to be deposited), thereby approximately uniformly irradiating the surface of the substrates W with the ion gas. The lateral central portion of Fig. 4B shows a curve schematically illustrating the distribution of the etch amount of the surface of the substrates W. The fact that the curve is similar to the vertical line can confirm that the etch amount of the surface of the substrates W is approximately uniform in the vertical direction.

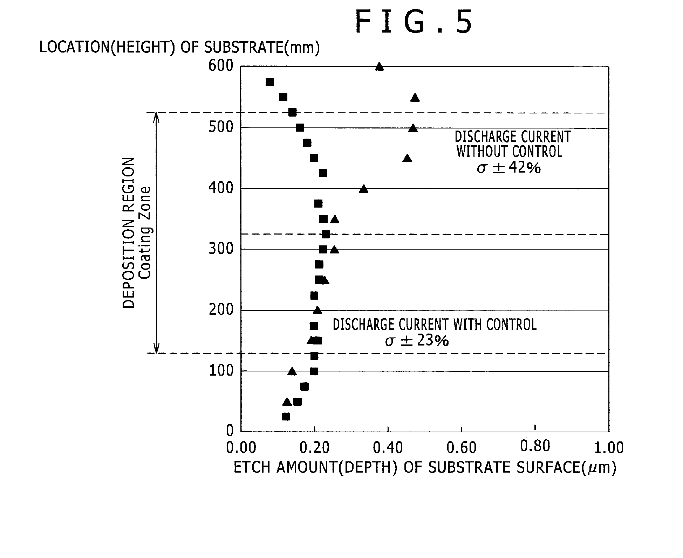

Fig. 5 illustrates the distribution of the etch amount of a substrate when no substrates W are placed in the upper area of the vacuum chamber 2. The group of black squares in Fig. 5 shows that when a substrate W is cleaned with control of the discharge current, the etch amount of the surface of the substrate W in the longitudinal direction of the substrate W is approximately uniform (about 0.20 µm) approximately across the coating zone (the location of the substrate W, ranging from about 120 mm to about 530 mm).

This means that the emitted electrons are present approximately uniformly between the electrode 3 and the anodes 4 without being affected by the shape and the placement of a substrate W. In other words, this means that regardless of the size and the placement of a substrate W in the vacuum chamber 2, the electrons are uniformly present in the chamber, and the density of plasmas generated in the vacuum chamber 2 is approximately uniform, thereby achieving approximately uniform etching of the substrate surface. The group of black squares in Fig. 5 shows that the etch amount is varied within a range of plus and minus 23% from σ (σ is the standard deviation).

Fig. 5 also illustrates, by black triangles, the distribution of the etch amount when cleaning a substrate without individual control of the discharge power sources 5 like conventional cleaning methods. For example, the discharge voltage of one of the plurality of discharge power sources 5 is set at 80 V, and the discharge voltage of the others of the plurality of discharge power sources 5 is in a master-slave relationship to follow the discharge voltage of 80 V. In such conditions, the surface of a substrate W is cleaned.

The group of black triangles in Fig. 5 shows that when a substrate W is cleaned without control of the discharge current, the etch amount of the surface of an upper portion of the substrate W (the portion ranging from 350 mm to 500 mm in the longitudinal direction of the substrate W) is much larger than the other portions. For example, at a level of 200 mm, which corresponds to the lower portion of the substrate W, the etch amount (depth) of the surface of the substrate W is 0.20 µm, while at a level of 500 mm, which corresponds to the upper portion of the substrate W, the etch amount (depth) of the surface of the substrate W is 0.45 µm.

This is because many of the emitted electrons pass through the area in which the substrates W are spaced, the area in which no substrates W are disposed, and/or the area in which the substrate W has less influence. As described above, some areas include a large number of electrons, while other areas include a small number of electrons, depending on the size and the placement of the substrate W in the vacuum chamber 2. This causes a non-uniform density of plasmas generated in the vacuum chamber 2, which causes variations in the etch amount of the surface of the substrate W. The group of black triangles in Fig. 5 shows that the etch amount is varied in a wide range of plus and minus 42% from σ.

To measure the etch amount of the surface of the substrate W to obtain the above results in this experimental example, a substrate W is selected from the plurality of substrates W placed on the work table 11, and the surface of the selected substrate W is masked by placing a stainless-steel plate on the surface. After cleaning the substrate W, the masking on the surface of the substrate W is removed to form an etched area from which material of the substrate W is removed and a non-etched area from which no material of the substrate W is removed. The etched area and the non-etched area together form a stepped portion on the surface of the substrate W. The etch amount of the surface of the substrate W can be determined by measuring the stepped portion.

As described above, use of the ion bombardment device 1 according to the first embodiment allows the plasma density in the vacuum chamber 2 to be approximately uniform, thereby approximately uniformly etching the surface of the substrates W, even if the substrates W disposed in the vacuum chamber 2 have different sizes and locations.

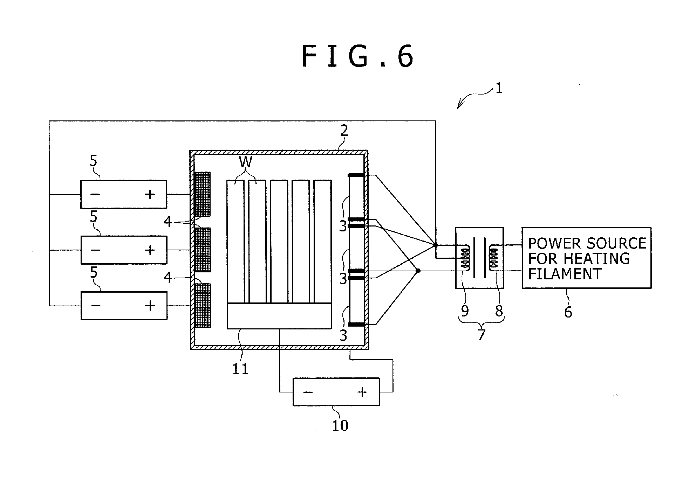

Next, a second embodiment of the present invention will be described with reference to Fig. 6.

Fig. 6 illustrates an ion bombardment device 1 according to the second embodiment. Similarly to the device according to the first embodiment, the ion bombardment device 1 according to the second embodiment includes an electrode unit that emits electrons, a plurality of anodes 4 that receive the electrons emitted from the electrode unit, a work table 11 that is a rotatable substrate holder on which a plurality of substrates W to be cleaned can be placed, a plurality of discharge power sources 5 that apply a potential difference between the electrode unit and each of the anodes 4 to generate a plasma discharge, a heating power source 6 for heating the electrode unit, and a bias power source 10 that applies a negative voltage to the substrates W placed on the work table 11.

In the device according to the second embodiment, the electrode unit is not a single electrode 3 constituted by an elongated filament as described in the first embodiment, and differs in that the unit includes a plurality of electrodes 3. These electrodes 3 are aligned with each other in the same orientation at a plurality of (three) locations that are arranged in the vertical direction, which is the longitudinal direction of the substrates W to be placed. Each of the electrodes 3 is disposed on one face of the inner wall of the vacuum chamber 2 and is opposed to a respective one of the three anodes 4 disposed on the opposite face of the inner wall of the vacuum chamber 2. The heating power source 6 is connected to both ends of each of the electrodes 3 and provides a current to the electrodes 3 to heat the electrodes 3, which are then caused to emit electrons.

Such alignment of the plurality of electrodes 3 in the vertical direction allows the region for treating the surface of the substrates W to be widened vertically, thereby cleaning the surface of the substrates W more uniformly across the longitudinal direction. Each of the electrodes 3 according to the second embodiment has a lower electrical resistance than the single elongated electrode 3 according to the first embodiment. Thus the electrodes are less likely to break, which allows prolonged use. If any of the electrodes 3 broke, the electrode could be readily exchanged for another.

Other configurations and other benefits of the second embodiment are approximately same as the first embodiment, and thus the description is omitted.

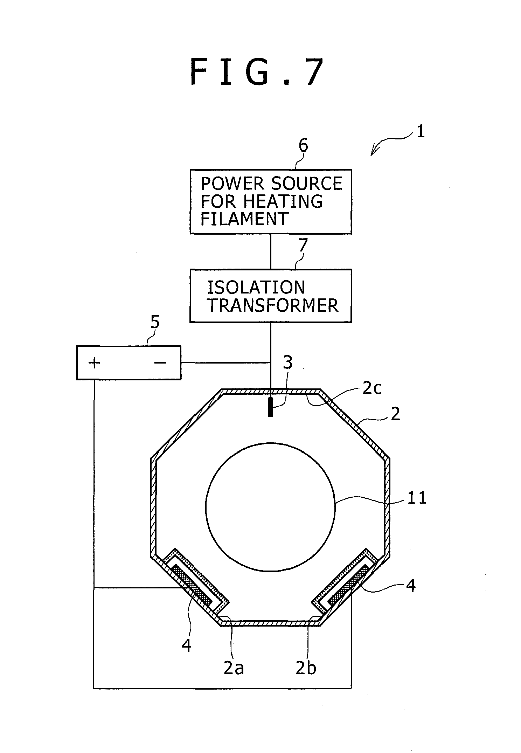

Next, a third embodiment of the present invention will be described with reference to Fig. 7.

Fig. 7 illustrates an ion bombardment device 1 according to the third embodiment. Similarly to the device according to the first embodiment, the device 1 includes a plurality of anodes 4, while the third embodiment significantly differs from the first embodiment in the location of the anodes 4. In particular, the anodes 4 illustrated in Fig. 7 are disposed on two (a left lower face 2a and a right lower face 2b in Fig. 7) of a plurality of faces that constitute the inner wall of a vacuum chamber 2 that has an octagonal plan view shape. Thus, the anodes 4 are disposed at a plurality of locations arranged in the lateral direction of the substrates W to be placed. The device according to the third embodiment also includes an electrode 3. The electrode 3 is disposed on one of the plurality of faces that constitute the inner wall of the vacuum chamber 2, which, in particular, is a face 2c (an upper face of the inner wall in the figure) facing, across the work table 11, the faces 2a and 2b that have the anodes 4. Thus, the electrode 3 and the two anodes 4 according to the third embodiment are disposed so that they are located at each vertex of a triangle when viewed in the plan view.

Provision of the plurality of anodes 4 at the plurality of locations arranged in the lateral direction of the substrates W allows the plasmas to be more widely distributed in the vacuum chamber 2 for cleaning the surface of the substrates W.

Other configurations and other benefits of the third embodiment are approximately same as the first embodiment, and thus the description is omitted.

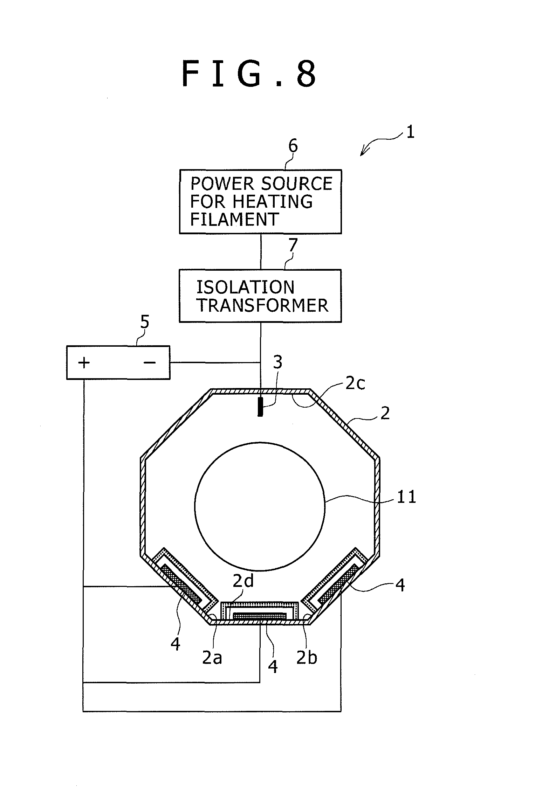

A fourth embodiment of the present invention will be described with reference to Fig. 8.

Fig. 8 illustrates an ion bombardment device 1 according to the fourth embodiment. The device 1 also includes a vacuum chamber 2, an electrode 3, and a plurality of anodes 4. Each of the anodes 4 is disposed on one of a plurality of faces that constitute the inner wall of the vacuum chamber 2, the face facing the electrode 3 across a work table 11 (one of faces 2a, 2d, and 2b arranged in the circumferential direction of the vacuum chamber 2). And the anodes 4 are misaligned in the lateral direction. In other words, the anodes 4 are disposed at different locations along the vertical direction, which is the longitudinal direction of the substrates W. For example, one of the plurality of anodes 4 is centered vertically in the face 2d, which is opposed to the face 2c that has the electrode 3, another anode 4 is disposed at an upper portion of the face 2a adjacent to the left side of the face 2d, and still another anode 4 is disposed at a lower portion of the face 2b adjacent to the right side of the face 2d. In the example, the plurality of anodes 4 is spirally disposed along the circumferential direction of the vacuum chamber 2. Alternatively, the anodes 4 may be staggered. In particular, the device can be configured so that one of the anodes 4 is centered vertically in a first face that constitutes the inner wall of the vacuum chamber 2, another anode 4 is disposed at an upper portion of a second face adjacent to the first face, and still another anode 4 is disposed at a lower portion of a third face adjacent to the second face.

The provision of a single anode 4 to a single face allows use of larger anodes 4, as viewed from the side. The anodes 4 can be electrically isolated from the vacuum chamber 2 by connecting the anodes 4 via an insulator to the respective faces. Then, the positive electrode of the discharge power sources 5 is connected to a respective one of the electrically-isolated anodes 4.

The embodiments disclosed above are to be considered in all respects as illustrative and not restrictive. In particular, features not expressly disclosed in the embodiments described herein, such as, for example, operating conditions, measurement conditions, various parameters, and sizes, weights, and volumes of the elements, may be employed, provided that such features come within customary practice in the art and that such features are readily apparent to those of ordinary skill in the art.

As described above, the present invention provides an ion bombardment device for cleaning a substrate surface, the device being capable of stably cleaning the surface regardless of variations in the size and the location of the substrate, and a method for using the device to clean a substrate surface.

The ion bombardment device includes a vacuum chamber that has an inner wall enclosing a space for containing a substrate, at least one electrode that is disposed on a face of the inner wall of the vacuum chamber and that emits electrons, a plurality of anodes that receive the electrons from the electrode and that are arranged so as to face so as to face the electrode across the substrate, and a plurality of discharge power sources that correspond to the respective anodes. Each of the discharge power sources is insulated from the vacuum chamber and provides an independently settable current or voltage to one of the anodes that corresponds to the discharge power source to generate a glow discharge between the anode and the electrode.

In the device, the substrate can be stably cleaned by adjusting at least one of the discharge current and the discharge voltage provided by each of the discharge power sources.

Preferably, the at least one electrode includes a plurality of electrodes that are disposed at locations that correspond to the respective anodes. The provision of the plurality of electrodes allows the region for treating the substrate surface to be widened, thereby more stably cleaning the surface of the substrate W.

The at least one electrode may include, for example, an elongated filament.

Preferably, each of the anodes includes an evaporation source for purposes of depositing a coating onto the substrate surface by physical vapor deposition or chemical vapor deposition, and the evaporation source includes a mechanism for generating a magnetic field to control the discharge. Use of the mechanism in the evaporation source allows control of electrons emitted from the electrode in the ion bombardment.

Each of the cathodes is disposed on a face of the inner wall of the vacuum chamber, the face facing the electrode, and more preferably, the anodes are disposed at a plurality of locations arranged in the longitudinal direction of the substrate to be placed in the vacuum chamber. Such placement of the anodes allows uniform cleaning of the substrate in the longitudinal direction to be achieved more readily.

The method for cleaning a substrate surface according to the present invention is a method for using the ion bombardment device as described above to clean the surface of a substrate prior to deposition, the substrate having a longitudinal direction, and includes placing the substrate in a space in the vacuum chamber so that the substrate is located between the at least one electrode and the anodes of the ion bombardment device, generating a glow discharge between the anodes and the electrode with the substrate placed to generate plasmas, and controlling at least one of a discharge current and a discharge voltage provided by each of the discharge power sources to achieve uniform density of the generated plasmas in the longitudinal direction of the substrate.

## Claims

1. An ion bombardment device for cleaning a substrate surface, the device comprising:
a vacuum chamber that has an inner wall enclosing a space for containing the substrate;
at least one electrode that is disposed on a face of the inner wall of the vacuum chamber and that emits electrons;
a plurality of anodes that receive the electrons from the electrode and that are arranged so as to face so as to face the electrode across the substrate; and
a plurality of discharge power sources that correspond to the respective anodes, wherein each of the discharge power sources is insulated from the vacuum chamber and provides an independently settable current or voltage to the anode that corresponds to the discharge power source to generate a glow discharge between the anode and the electrode.

2. The ion bombardment device according to claim 1, wherein the at least one electrode comprises a plurality of electrodes that are disposed at locations that correspond to the respective anodes.

3. The ion bombardment device according to claim 1, wherein the at least one electrode comprises an elongated filament.

4. The ion bombardment device according to claim 1, wherein each of the anodes comprises an evaporation source for purposes of depositing a coating onto the substrate surface by physical vapor deposition or chemical vapor deposition, and wherein the evaporation source comprises a mechanism for generating a magnetic field to control the discharge.

5. The ion bombardment device according to claim 1, wherein each of the anodes is disposed on a face of the inner wall of the vacuum chamber, the face facing the electrode, and wherein the anodes are disposed at a plurality of locations arranged in the longitudinal direction of the substrate to be placed in the vacuum chamber.

6. A method for using the ion bombardment device according to any of claims 1-5 to clean the surface of a substrate prior to deposition, the substrate having a longitudinal direction, the method comprising:
placing the substrate in a space in the vacuum chamber so that the substrate is located between the at least one electrode and the anodes of the ion bombardment device;
generating a glow discharge between the anodes and the electrode with the substrate placed to generate plasmas; and
controlling at least one of a discharge current and a discharge voltage provided by the discharge power sources to achieve uniform density of the generated plasmas in the longitudinal direction of the substrate.
